# EUROPEAN PATENT APPLICATION

(11) **EP 1 601 012 A2**
(43) Date of publication of application: **30.11.2005**
(21) Application number: 05076018.0
(22) Date of filing: 02.05.2005
(51) Int. Cl.: H01L 21/60, H01L 29/06

(54) **Microelectronic assembly having variable thickness solder joint**

(30) Priority: 12.05.2004 US 844065
(71) Applicant: Delphi Technologies, Inc., Troy, MI 48007 (US)
(72) Inventor: Runyon, Ronnie J., Kokomo IN 46902 (US); Berndt, Joanna C., Kokomo IN 46901 (US); Oberlin, Gary E., Windfall IN 46076 (US)
(74) Representative: Denton, Michael John

(57) **Abstract**

A microelectronic assembly (10,100) includes a component (12,102) attached to a substrate (14,104) by a variable thickness solder joint (30,108) . The solder joint comprises a first thickness (t1) adjacent the central region (20,110) of the component and a second, relatively greater thickness (t2) adjacent the perimeter region (22,112) of the component. The variable thickness solder joint may be used for attaching a power die to a metal heat sink on a printed circuit board (16,106), so that the relatively thin central portion promotes thermal dissipation to maintain the die within a desired operating temperature range, and the relatively thick perimeter region distributes thermally induced stresses to enhance joint strength and reduce fatigue cracking.

## Description

### TECHNICAL FIELD

This invention relates to a microelectronic assembly wherein a component is attached to a substrate by a solder layer, and more particularly, to such assembly wherein the solder layer is thinner at the central section of the component than at the perimeter.

### BACKGROUND OF THE INVENTION

In a typical microelectronic assembly, heat generated by a power die or other component may be dissipated to a substrate to maintain the component within a desired operating temperature range. For example, a power die, such as a field effect transistor, referred to as an FET, or an insulated gate bipolar transistor device, referred to as an IGBT, may be attached to a heat sink on a printed circuit board. In another type of assembly, the power die may be attached to a tab and incorporated into an overmolded package that is subsequently clamped to a heat sink. The substrate to which the die is attached is preferably formed of a metal having high thermal conductivity, typically copper, whereas the power die is formed of silicon and is soldered to the substrate. To form the assembly, the die and the substrate are arranged with a solder material therebetween, and the arrangement is heated and cooled to reflow the solder, thereby forming a solder joint bonding the component to the substrate.

During operation, the assembly experiences cyclic heating and cooling that causes the power die and the substrate to expand and contract, but at different rates characteristic of the materials. The rate of expansion is referred to as the coefficient of thermal expansion, referred to as CTE, and is measured a parts per million (ppm) per degree Centigrade (°C). Because of the difference between the CTE of the silicon die and the CTE of the copper heat sink, stress occurs within the solder layer that causes fatigue of the solder metal and lead to cracking of the joint and failure of the assembly. Heretofore assemblies have been formed having solder layers having a uniform thickness. In general, increasing the thickness of the solder reduces the concentration of stress therein. However, solder tends to exhibit a relatively low thermal conductivity compared to copper or other heat sink metals, so that thicker solder reduces heat transfer form the die and is less effective for purposes of maintaining the die within a desired operating temperature range.

Therefore, a need exists for a microelectronic assembly having an improved solder joint for attaching a power die or other component, to a substrate, such as a copper heat sink or tab, that reduces thermally induced stress within the joint and prolongs the useful life of the assembly, while facilitating heat dissipation from the component into the substrate to maintain the component within a desired operating temperature range.

### SUMMARY OF THE INVENTION

In accordance with this invention, a microelectronic assembly comprises a component, such as a power die, attached to a substrate by a solder layer. The component face includes a central region surrounded by a perimeter region. The solder layer is characterized by a first thickness underlying the central region, and a second thickness underlying the perimeter region that is greater than the first thickness. Thus, the solder layer is thinner in the central section, to promote heat transfer from the component to the substrate. Further, the solder layer is greater at the perimeter where stresses due to thermal expansion mismatch tend to accumulate, and so is better able to resist fatigue that might otherwise result in failure of the device.

### BRIEF DESCRIPTION OF THE DRAWINGS

This invention will be further described with reference to the accompanying drawings in which:
Fig. 1 is a cross sectional view of a microelectronic assembly having a variable thickness solder bond in accordance with this invention, and
Fig. 2 is a cross sectional view of a microelectronic assembly in accordance with an alternate embodiment of this invention.

### DESCRIPTION OF THE PREFERRED EMBODIMENT

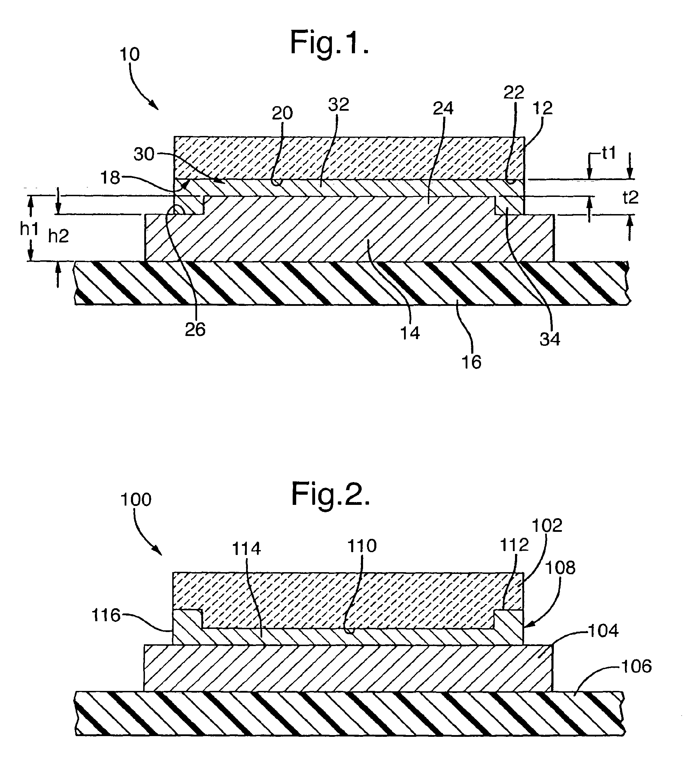

In accordance with a preferred embodiment of this invention, referring to Fig. 1, a microelectronic assembly 10 comprises a surface mount component 12 attached to a substrate 14 carried on a printed circuit board 16. By way of a preferred example, component 12 is a power die formed of silicon, such as an FET or IGBT device, and is attached to a substrate that is formed of copper or other metal having a high heat capacity. During operation, heat generated by the component is transferred to and dissipated by the substrate, so that the substrate serves as a heat sink. In addition to serving as a heat sink, substrate 12 may have other uses, such as a bus bar. Optionally, assembly 10 may include an overmolded polymeric body encapsulating the component. While this invention is particularly useful for power die that generate high heat during operation, it may also be suitably employed with low power devices which, because of environmental or other reasons, requires enhanced thermal dissipation to maintain a desired low temperature for optimum operation.

In this embodiment, component 12 features a major face 18 that is planar and parallel to board 16. Face 18 includes a central region 20 surrounded by a perimeter region 22. Substrate 14 also includes a central section 24 underlying component central region 20 and a perimeter section 26 outboard from central section 24 and underlying component perimeter 22. In this embodiment, central section 24 of substrate 14 has a height h1 perpendicular to board 16 that is greater than the height h2 of the perimeter. Substrate 14 may be suitably made by attaching or forming a metal layer having a uniform thickness to the board and machining the perimeter to reduce the thickness thereof. Alternately, the substrate may be formed by affixing a pedestal to a thin metal film, so that the film forms the perimeter and the spacer provides the added height for the central section

Component 12 is attached to substrate 14 by a solder joint 30 having a variable thickness. Solder joint 30 is formed of a continuous layer of solder alloy, and includes a central portion 32 and a perimeter portion 34. Joint 30 may be formed of any suitable solder alloy adapted to form a metallurgical bond to the component and the substrate. A preferred solder alloy is composed of a near-eutectic tin-lead alloy comprising 60 percent tin and the balance lead. Central portion 32 is disposed between central region of component face 18 and central section 24 of substrate 14 and is characterized by a first thickness t1. Perimeter portion 34 is disposed between perimeter 22 of component face 18 and perimeter 26 of substrate 14 and is characterized by a second thickness t2. In accordance with this invention, central thickness t1 is less than the perimeter thickness t2.

During operation, heat generated by component 12 is dissipated to substrate 14 through joint 30. This is accompanied by a rise in the temperature of the component and, to a lesser extent, the substrate, and expansion of the component and heat sink. Because of the differences in CTE, for example, in assemblies comprising silicon and copper, a mismatch occurs between the expansion of the component relative to the substrate and produces shear stress within the solder layer. While not limited to any particular theory, it is believed that a solder joint having a variable thickness in accordance with this invention reduces stress within the solder layer without retarding heat transfer to the substrate. In general, it is desired to provide a sufficient thickness of solder within the central portion to assure a continuous metallurgical bond to prevent detachment of the component, while minimizing thermal resistance. It is believed that central portion 32 may be suitably formed having a thickness less than about 0.12 mm (5 mils), and preferably between about 0.05 and 0.10 mm (2 and 4 mils). At the perimeter, it is desired to provide a sufficient thickness of solder to distribute the thermally induced stresses to below tolerable limits for the solder material that might otherwise result in crack formation. The optimum thickness for the perimeter solder is dependent upon several factors including the width of the component and the relative CTE of the materials, as they relate to the heat generated by the component and the maximum expected operating temperature. In general, it is believed that a perimeter thickness greater than about 0.20 mm (8 mils), and preferably between about 0.20 and 0.25 mm (8 and 10 mils), is suitable to enhance joint strength and avoid fatigue crack formation in assemblies of silicon die and a copper substrate. The overall strength of the joint is also dependent upon the width of the perimeter portion. Thus, joint strength may be increased by increasing the width of the perimeter portion. It is generally desired to maximize the central portion to facilitate heat transfer. In general, the joint may be designed so that the width of the central portion is between about 60 and 90 percent of the component width, with the perimeter evenly divided thereabout and between about 5 and 20 percent of the component width.

A variable thickness solder joint in accordance with this invention was evaluated and compared to solder joints having uniform thickness using finite element analysis. The analysis was based upon a square silicon die mounted on a copper substrate, and having a total width of 7 mm and a central region that was 5 mm wide. The joints were formed of near-eutectic solder and included a central thickness of 3 mils (0.076 mm) and a perimeter thickness of 10 mils (0.25 mm). When compared to a uniform solder layer that is 10 mils (0.25 mm) thick, the variable solder joint exhibited comparable shear stress values and a 22 percent improvement in thermal resistance. When compared to a uniform solder joint that is 3 mils (0.076 mm) thick, the variable thickness solder joint exhibited a 50 percent reduction in shear stress, with only a 22 percent increase in thermal resistance. Thus, the variable thickness solder joint exhibited an optimum combination of both lowered shear stress and enhanced thermal conductivity.

Referring now to Fig. 2, there is depicted a microelectronic assembly 100 in accordance with an alternate embodiment of this invention. Assembly 100 comprises a substrate 104 on a printed circuit board 106 and a component 102 attached to the substrate by a solder layer 108. Component 102 may be a power die formed of silicon, and substrate 104 may be formed of copper, similar to the preferred components set forth for the embodiment in Fig. 1. In this embodiment, substrate 104 has a uniform thickness, whereas the face of component 102 is machined to define a central region 110 and a perimeter region 112, such that the component is thicker in the central region than at the perimeter. When arranged with the substrate, solder layer 108 features a thin central portion 114 between the central region of the component and the substrate, and a thick perimeter portion 116 between the perimeter region of the die and the substrate. Thus the solder layer features a thin central section to facilitate heat transfer to the substrate that serves as a heat sink, and a thick perimeter section to reduce shear stress within the joint.

Therefore, this invention provides an assembly that includes a component attached to a substrate by a robust solder joint. The solder joint resists fatigue due to thermally induced stresses that result from CTE mismatch between the component and the substrate. In addition, the thin section of the solder joint promotes heat transfer to the substrate to maintain the component within a desired operating temperature range. This may be readily accomplished using conventional processes to pattern the surface of either the component or substrate, and without requiring additional components or assembly steps. In the described embodiments, the component is attached to a substrate that comprises a relatively large mass of high thermal conductivity metal to serve as a heat sink and optimize thermal dissipation. Alternately, the component may be attached to tab such as found in an overmolded package, or other suitable metal carrier or support, where it is desired to enhance joint strength while reducing central solder thickness.

While this invention has been described in terms of the preferred embodiments thereof, it is not intended to be so limited, but rather only to the extent set forth in the claims that follow.

## Claims

1. A microelectronic assembly comprising
a substrate,
a component having a component face facing the substrate and spaced apart therefrom, said component face comprising a central region and a perimeter region, and
a solder joint bonding the component to the substrate, said solder joint being **characterized by** a first thickness adjacent the central region and a second thickness adjacent the perimeter region, wherein the first thickness is less than the second thickness.

2. A microelectronic assembly in accordance with claim 1 wherein the substrate is formed of a metal.

3. A microelectronic assembly in accordance with claim 1 wherein the component is a power die.

4. A microelectronic assembly in accordance with claim 1 wherein the component is a field effect transistor device.

5. A microelectronic assembly in accordance with claim 1 wherein the substrate is mounted on a printed circuit board.

6. A microelectronic assembly in accordance with claim 1 wherein the substrate includes a central section underlying the central region of the component face and a perimeter section underlying the perimeter region of the component face, and wherein the substrate is **characterized by** a first thickness at the central section and a second thickness at the perimeter section, such that the first thickness is greater than the second thickness.

7. A microelectronic assembly in accordance with claim 1 wherein the component has a thickness at the central region greater than a thickness at the perimeter region.

8. A microelectronic assembly in accordance with claim 1 wherein the substrate is a heat sink adapted for dissipating heat from the component through the solder layer.

9. A microelectronic assembly in accordance with claim 1 wherein the first thickness is less than 0.12 mm, and the second thickness is greater than 0.20 mm.

10. A microelectronic assembly in accordance with claim 1 wherein the first thickness is between about 0.05 and 0.10 mm.

11. A microelectronic assembly in accordance with claim 1 wherein the second thickness is between about 0.20 and 0.25 mm.

12. A microelectronic assembly in accordance with claim 1 wherein the component has a component width, and wherein the central region of the component face has a width between about 60 and 90 percent of the component width.

13. A microelectronic assembly comprising
a printed circuit board,
a substrate mounted on the printed circuit board and formed of a metal,
a die having a die face facing the substrate and comprising a central region and a perimeter region, said die being **characterized by** a die width, said central region having a width between about 60 and 90 percent of said die width, and
a solder joint bonding the die face to the substrate, said solder joint having a central portion interposed between the central region of the die and the substrate and **characterized by** a first thickness less than 0.12 mm and a perimeter portion interposed between the perimeter region of the die and the substrate and **characterized by** a second thickness greater than the first thickness.

14. A microelectronic assembly in accordance with claim 13 wherein the second thickness is greater than 0.20 mm.

15. A microelectronic assembly in accordance with claim 13 wherein the first thickness is between about 0.05 and 0.10 mm and the second thickness is between about 0.20 and 0.25 mm.
